(19)

Europäisches Patentamt

European Patent Office

Office européen des brevets

(11)  **EP 4 738 698 A1**

(12)  **EUROPEAN PATENT APPLICATION**

(43) Date of publication:
06.05.2026  Bulletin 2026/19

(21) Application number: 25183987.4

(22) Date of filing: 19.06.2025

(51) International Patent Classification (IPC):
**H03B 5/12** (2006.01)

(52) Cooperative Patent Classification (CPC):
**H03B 5/1212; H03B 5/1228; H03B 2200/0088**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH LA MA MD TN**

(30) Priority:  04.11.2024  US 202463715681 P
23.05.2025  US 202519216744

(71) Applicant: **MEDIATEK INC.**
**Hsinchu City 30078 (TW)**

(72) Inventors:
• **CHEN, Jiun-Yan**
**30078 Hsinchu City (TW)**
• **HUNG, Chao-Ching**
**30078 Hsinchu City (TW)**
• **HSUEH, Yu-Li**
**30078 Hsinchu City (TW)**

(74) Representative: **Pfenning, Meinig & Partner mbB**
**Patent- und Rechtsanwälte**
**Joachimsthaler Straße 10-12**
**10719 Berlin (DE)**

(54)  **OSCILLATOR CIRCUITS WITH FLICKER NOISE SUPPRESSION BY PHASE-SHIFTED SELF-INJECTION**

(57)  An oscillator circuit (100, 300) includes a first cross coupled pair (110, 310), a second cross coupled pair (120, 320), a resonant circuit (130) coupled between the first cross coupled pair (110, 310) and the second cross coupled pair (120, 320) and a first injection circuit (140-1, 340-1). The resonant circuit (130) includes a first node outputting a first voltage signal (VoscP) and a second node outputting a second voltage signal (VoscN). The first injection circuit (140-1, 340-1) is coupled to the first cross coupled pair (110, 310) and injects a first compensating current with a first predetermined phase to a predetermined node of the first cross coupled pair (110, 310).

FIG. 1

**Description**

Field of the Invention

This invention relates to an oscillator circuit capable of suppressing flicker noise by phase-shifted self-injection.

Background of the Invention

Current noise significantly impacts the performance of oscillator circuits, primarily reflected in the degradation of phase noise. When current noise is injected into the oscillator's resonant circuit, the noise signal propagates through the resonant circuit and the oscillator's gain path, affecting the output signal. The injected current noise influences the oscillator's instantaneous phase, leading to phase deviations. The phase deviation of the oscillator is sensitive to the timing of the current noise injection. For the injected current noise with the same magnitude, different phase deviations are generated as the time of injection into the oscillator is different.

Impulse Sensitivity Function (ISF) is a mathematical model used to describe the sensitivity of oscillators to external perturbations, particularly in the analysis of phase noise. ISF is represented as $\Gamma(x)$, which characterizes the oscillator's response to unit impulses at different points within its cycle. The more symmetric the curve of ISF, the better the flicker noise suppression capability of the oscillator circuit. However, due to the nonlinear characteristics of oscillator circuits, ISF curves are often asymmetrical.

Therefore, improving the symmetry of the ISF curve to enhance noise suppression capability is an important issue in oscillator circuit design.

Summary of the Invention

The invention aims at providing an oscillator circuit which can suppress flicker noise by phase-shifted self-injection. This is achieved by oscillator circuits according to claims 1 and 8. The dependent claims pertain to corresponding further developments and improvements.

As will be seen more clearly from the detailed description below, the oscillator circuit according to a first embodiment comprises a first cross coupled pair, a second cross coupled pair, a resonant circuit coupled between the first cross coupled pair and the second cross coupled pair and a first injection circuit. The resonant circuit comprises a first node outputting a first voltage signal and a second node outputting a second voltage signal. The first injection circuit is coupled to the first cross coupled pair and injects a first compensating current with a first predetermined phase to a predetermined node of the first cross coupled pair.

As will be seen more clearly from the detailed description below, the oscillator circuit according to another embodiment comprises a first cross coupled pair, a second cross coupled pair, a resonant circuit coupled between the first cross coupled pair and the second cross coupled pair and a plurality of injection circuits. The resonant circuit comprises a first node outputting a first voltage signal and a second node outputting a second voltage signal. Each injection circuit is coupled to one of the first cross coupled pair and the second cross coupled pair and injects a compensating current with a predetermined phase to a predetermined node of the one of the first cross coupled pair and the second cross coupled pair. One of the injection circuits comprises a filter circuit and a feedthrough circuit. The filter circuit is coupled to the predetermined node of the one of the first cross coupled pair and the second cross coupled pair and receives one of the first voltage signal and the second voltage signal. The feedthrough circuit is coupled to the filter circuit and provides a current path between the predetermined node and a power supply node.

Brief Description of the Drawings

In the following, the invention is further illustrated by way of example, taking reference to the following drawings. Thereof:

FIG. 1    shows a schematic diagram of an oscillator circuit according to an embodiment of the invention.

FIG. 2    shows an exemplary circuit diagram of an injection circuit according to an embodiment of the invention.

FIG. 3    shows an exemplary circuit diagram of an oscillator circuit according to a first embodiment of the invention.

FIG. 4    shows an exemplary circuit diagram of an oscillator circuit according to a second embodiment of the invention.

FIG. 5    depicts an exemplary circuit diagram of an injection circuit to illustrate the relationship between the drain current and the gate voltage according to an embodiment of the invention.

FIG. 6    is a schematic diagram showing the generation of symmetric effective ISF which is achieved by injecting the compensating current with a predetermined phase according to an embodiment of the invention.

FIG. 7     is a schematic diagram showing the phase of the load when looking into the resonant circuit according to an embodiment of the invention.

Detailed Description

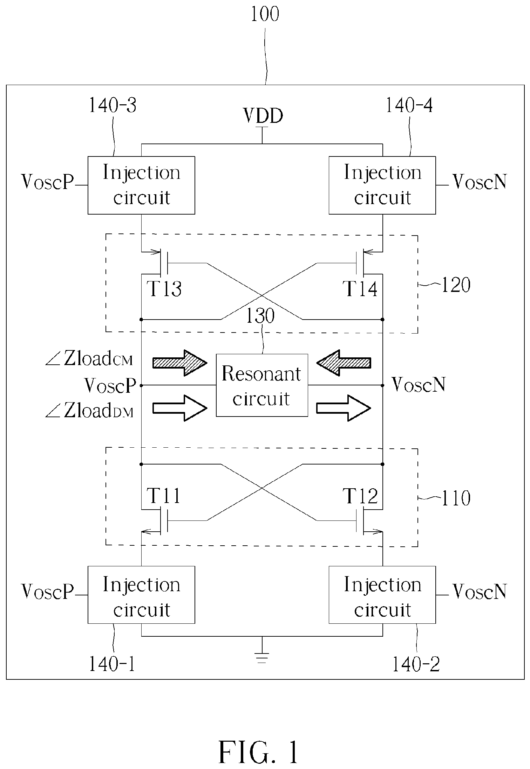

FIG. 1 shows a schematic diagram of an oscillator circuit according to an embodiment of the invention. The oscillator circuit 100 may comprise cross coupled pairs 110 and 120, a resonant circuit 130 and one or more injection circuits, such as the injection circuits 140-1, 140-2, 140-3 and 140-4. The resonant circuit 130 is coupled between the cross coupled pairs 110 and 120 and comprises a first node outputting the voltage signal VoscP and a second node outputting the voltage signal VoscN.

According to an embodiment of the invention, an injection circuit is coupled to one of the cross coupled pairs 110 and 120 and injects a compensating current with a predetermined phase to a predetermined node of the one of the cross coupled pairs 110 and 120. In the embodiments of the invention, the predetermined phase is a 90-degree (or, nearly 90-degree) phase, and the predetermined node is a node connecting to a source electrode of a transistor comprised in the one of the cross coupled pairs 110 and 120.

More specifically, the cross coupled pair 110 comprises transistors T11 and T12, and the cross coupled pair 120 comprises transistors T13 and T14. Each of transistors T11, T12, T13 and T14 comprises a drain electrode (e.g., first electrode), a gate electrode (e.g., second electrode) and a source electrode (e.g., third electrode). The drain electrode of the transistor T11 is coupled to the gate electrode of the transistor T12, and the drain electrode of the transistor T12 is coupled to the gate electrode of the transistor T11, forming the cross coupled pair 110. Similarly, the drain electrode of the transistor T13 is coupled to the gate electrode of the transistor T14, and the drain electrode of the transistor T14 is coupled to the gate electrode of the transistor T13, forming the cross coupled pair 120.

In addition, the drain electrodes of the transistors T11 and T13 are coupled to the first node of the resonant circuit 130 outputting the voltage signal VoscP, and the drain electrodes of the transistors T12 and T14 are coupled to the second node of the resonant circuit 130 outputting the voltage signal VoscN.

According to an embodiment of the invention, there is a 180-degree phase shift between the voltage signal VoscP and the voltage signal VoscN. In addition, according to an embodiment of the invention, the voltage signal VoscP is provided to the injection circuits 140-1 and 140-3, and the voltage signal VoscN is provided to the injection circuits 140-2 and 140-4.

According to an embodiment of the invention, the injection circuit 140-1 is coupled to the source electrode of the transistor T11 (or, a first predetermined node of the cross coupled pair 110 connecting to the source electrode of the transistor T11). The injection circuit 140-1 receives the voltage signal VoscP and injects a first compensating current with a first predetermined phase to the first predetermined node of the cross coupled pair 110 in response to the voltage signal VoscP.

The injection circuit 140-2 is coupled to the source electrode of the transistor T12 (or, a second predetermined node of the cross coupled pair 110 connecting to the source electrode of the transistor T12). The injection circuit 140-2 receives the voltage signal VoscN and injects a second compensating current with a second predetermined phase to the second predetermined node of the cross coupled pair 110 in response to the voltage signal VoscN.

The injection circuit 140-3 is coupled to the source electrode of the transistor T13 (or, a first predetermined node of the cross coupled pair 120 connecting to the source electrode of the transistor T13). The injection circuit 140-3 receives the voltage signal VoscP and injects a third compensating current with a third predetermined phase to the first predetermined node of the cross coupled pair 120 in response to the voltage signal VoscP.

The injection circuit 140-4 is coupled to the source electrode of the transistor T14 (or, a second predetermined node of the cross coupled pair 120 connecting to the source electrode of the transistor T14). The injection circuit 140-4 receives the voltage signal VoscN and injects a fourth compensating current with a fourth predetermined phase to the second predetermined node of the cross coupled pair 120 in response to the voltage signal VoscN.

According to an embodiment of the invention, the first compensating current injected to the source electrode of the transistor T11 is a current with a 90-degree phase (i.e., the first the predetermined phase) or a nearly 90-degree phase with respect to the gate voltage $V_G$ of the transistor T11. That is, in an embodiment of the invention, a phase difference between the injected first compensating current and the gate voltage $V_G$ of the transistor T11 is 90-degree or nearly 90-degree.

The second compensating current injected to the source electrode of the transistor T12 is a current with a 90-degree phase (i.e., the second the predetermined phase) or a nearly 90-degree phase with respect to the gate voltage $V_G$ of the transistor T12. That is, in an embodiment of the invention, a phase difference between the injected second compensating current and the gate voltage $V_G$ of the transistor T12 is 90-degree or nearly 90-degree.

The third compensating current injected to the source electrode of the transistor T13 is a current with a 90-degree phase (i.e., the third the predetermined phase) or a nearly 90-degree phase with respect to the gate voltage $V_G$ of the transistor T13. That is, in an embodiment of the invention, a phase difference between the injected third compensating current and the gate voltage $V_G$ of the transistor T13 is 90-degree or nearly 90-degree.

The fourth compensating current injected to the source electrode of the transistor T14 is a current with a 90-degree phase (i.e., the fourth the predetermined phase) or a nearly 90-degree phase with respect to the gate voltage $V_G$ of the transistor T14. That is, in an embodiment of the invention, a phase difference between the injected fourth compensating current and the gate voltage $V_G$ of the transistor T14 is 90-degree or nearly 90-degree.

According to an embodiment of the invention, each of the one or more injection circuits, such as the injection circuits 140-1, 140-2, 140-3 and 140-4, comprises a filter circuit and a feedthrough circuit. The filter circuit may be a high pass filter or a bandpass filter, and the feedthrough circuit may be a direct current (DC) feedthrough circuit coupled to the filter circuit and providing a current path between the predetermined node of the corresponding cross coupled pair and a power supply node, such as the power supply node supplying the power voltage VDD or the power supply node supplying the ground voltage GND.

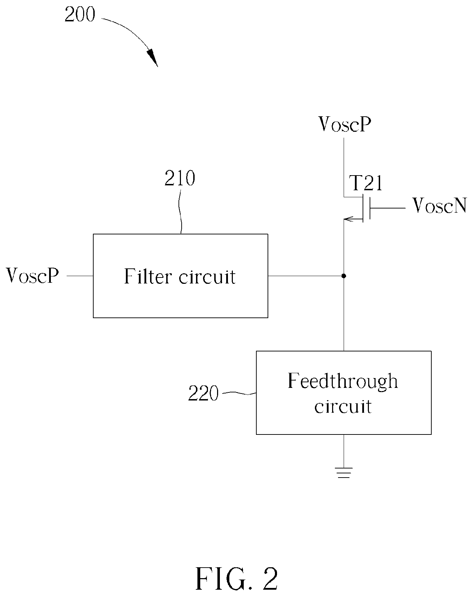

FIG. 2 shows an exemplary circuit diagram of an injection circuit according to an embodiment of the invention. The injection circuit 200 may be an implementation of the injection circuit 140-1, and may comprise a filter circuit 210 and a feedthrough circuit 220.

The filter circuit 210 is coupled to the source electrode of the transistor T21 of the corresponding cross coupled pair and receives the voltage signal VoscP. The filter circuit 210 high pass or bandpass filtering the received voltage signal VoscP and provides the filtered voltage signal to the source electrode of the transistor T21 of the corresponding cross coupled pair, contributing the compensating current injected to the source electrode of the transistor T21. The feedthrough circuit 220 provides the corresponding cross coupled pair a DC current path to the ground voltage GND.

According to an embodiment of the invention, the injection circuit 200 injects the compensating current with a positive 90-degree phase or a substantially positive 90-degree phase to the source electrode of the transistor T21 in response to the voltage signal VoscP. According to an embodiment of the invention, the phase difference between the injected compensating current and the gate voltage $V_G$ of the transistor T21 is 90-degree or nearly 90-degree.

Note that the injection circuits 140-2, 140-3 and 140-4 share a similar structure with the injection circuit 140-1. Based on the structure depicted in FIG. 2, those skilled in the art can readily derive the circuit diagrams for the injection circuits 140-2, 140-3, and 140-4. Therefore, the exemplary circuit diagrams for these injection circuits are omitted here for the sake of brevity.

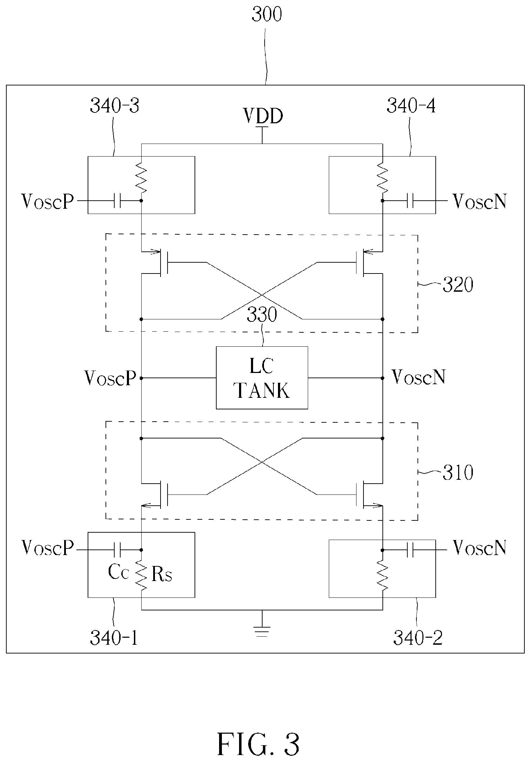

FIG. 3 shows an exemplary circuit diagram of an oscillator circuit according to a first embodiment of the invention. The oscillator circuit 300 may comprise cross coupled pairs 310 and 320, a resonant circuit coupled between the cross coupled pairs 310 and 320 and one or more injection circuits, such as the injection circuits 340-1, 340-2, 340-3 and 340-4. In this embodiment, the resonant circuit is implemented by an LC tank 330 and comprises a first node outputting the voltage signal VoscP and a second node outputting the voltage signal VoscN.

In addition, in this embodiment, each injection circuit comprises a high pass filter and a DC feedthrough circuit. The high pass filter may be implemented by a capacitor, such as the capacitor $C_C$ comprised in the injection circuit 340-1, and the DC feedthrough circuit may be implemented by a resistor, such as the resistor $R_S$ comprised in the injection circuit 340-1.

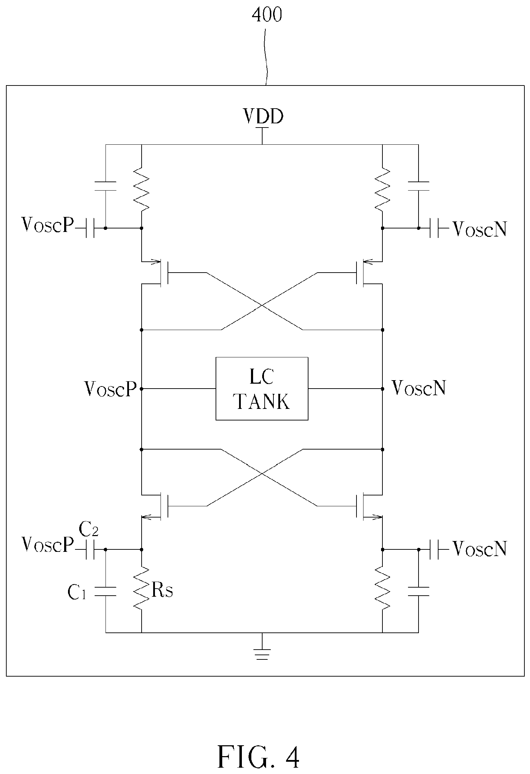

FIG. 4 shows an exemplary circuit diagram of an oscillator circuit according to a second embodiment of the invention. Each injection circuit comprises a high pass filter and a DC feedthrough circuit. The main difference between the oscillator circuit 400 depicted in FIG. 4 and the oscillator circuit 300 depicted in FIG. 3 is in that the high pass filter is implemented by more than one capacitor, such as the capacitors $C_1$ and $C_2$ shown in FIG. 4.

According to an embodiment of the invention, the injection circuit injects a current with a positive 90-degree phase-shift to the source electrode of the transistor in the corresponding cross coupled pair, implementing a phase self-injection to change the relationship between the drain current $I_D$ and the gate voltage $V_G$ of the transistor which results in a symmetric effective ISF curve of the oscillator circuit.

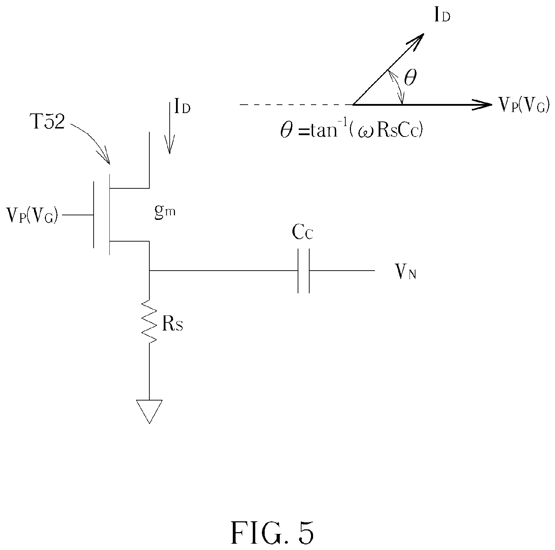

FIG. 5 depicts an exemplary circuit diagram of an injection circuit to illustrate the relationship between the drain current $I_D$ and the gate voltage $V_G$ according to an embodiment of the invention. In this embodiment, the gate voltage $V_P$ ($V_G$) is VoscP, and the voltage $V_N$ is VoscN.

In the embodiments of the invention, a phase difference between the injected compensating current and the gate voltage $V_G$ of the transistor T52 is 90-degree or nearly 90-degree, and the injection of the compensating current causes a change in the phase between the drain current $I_D$ and the gate voltage $V_G$ of the transistor T52. The drain current $I_D$ is expressed as the following equation Eq. (1):

$$I_D \approx \left( g_m \cdot \frac{1}{1+g_m \cdot R_S} + s \cdot C_C \cdot \frac{g_m}{g_m + \frac{1}{R_S}} \right) \cdot V_P \qquad \text{Eq. (1)}$$

where the latter portion ( $s \cdot C_C \cdot \frac{g_m}{g_m + \frac{1}{R_S}} \cdot V_P$ ) of the drain current $I_D$ is contributed by the injected compensating current which has a positive 90-degree phase. The positive 90-degree phase is due to the capacitor(s) (such as the capacitor $C_C$) comprised in the injection circuit. The positive 90-degree phase turns the phase of the current noise, and the resulting phase between the drain current $I_D$ and the gate voltage $V_G$ is $\theta$ is shown in FIG. 5.

In the embodiments of the invention, the phase of the current noise is turned by injecting the compensating current as described above, and the purpose to change the phase of the current noise is to make the effective ISF curve of the oscillator circuit symmetric.

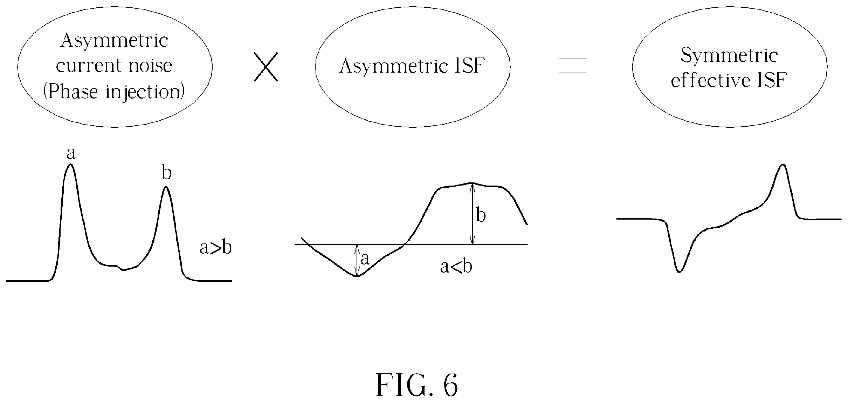

FIG. 6 is a schematic diagram showing the generation of symmetric effective ISF which is achieved by injecting the compensating current with a predetermined phase according to an embodiment of the invention.

Since the current noise is actually time-variant, the effective ISF $\Gamma_{eff}(x)$ which considers the cyclostationary current noise $\alpha(x)$ is utilized as a measure of flicker noise suppression capability, and is expressed as the following equation Eq. (2):

$$\Gamma_{eff}(x) = \Gamma(x) \cdot \alpha(x) \qquad \text{Eq. (2)}$$

where the parameter x represents the time point.

In FIG. 6, the waveform of asymmetric current noise with phase injection (which is generated in the proposed oscillator circuit with phase self-injection) is shown on the left side, the waveform of asymmetric ISF is shown in the middle, and the waveform of resulting effective ISF is shown on the right side.

In the embodiments of the invention, by controlling the predetermined phase of the injected compensating current, the asymmetric waveform of the ISF is compensated by the current noise with phase injection. For example, in the ISF curve, the magnitude at point a is smaller than the magnitude at point b. To compensate for this, the compensating current with a leading positive 90-degree phase is injected to source electrode of the corresponding transistor to shift the phase of the current noise, resulting in the magnitude at point a to become greater than the magnitude at point b. After the combination of the current noise and the ISF as expressed in Eq. (2), the waveform of resulting effective ISF is symmetric. Therefore, for the proposed oscillator circuit with phase self-injection, the flicker noise suppression capability is greatly improved.

According to an embodiment of the invention, the phase of the current noise:

$$\theta = tan^{-1}(\omega R_S C_C) \qquad \text{Eq. (3)}$$

(for example but not limited to, the capacitance of the capacitor $C_C$ as shown in FIG. 3 or the capacitance of the capacitors of $C_1$ and $C_2$ as shown in FIG. 4) is flexibly adjusted based on the asymmetry of the ISF curve.

Note that since only resistor(s) and capacitor(s) are required in the injection circuit, the injection circuits occupy very small circuit area. Especially when being compared with the conventional design which adopts a second harmonic tail tank including the inductors, the circuit area required in the proposed oscillator for compensating for the asymmetry of the ISF is greatly reduced. In addition, the proposed oscillator circuit has not only good flicker noise suppression capability, but also supports wideband operation. Therefore, no second harmonic tuning circuit is required as compared to the conventional design.

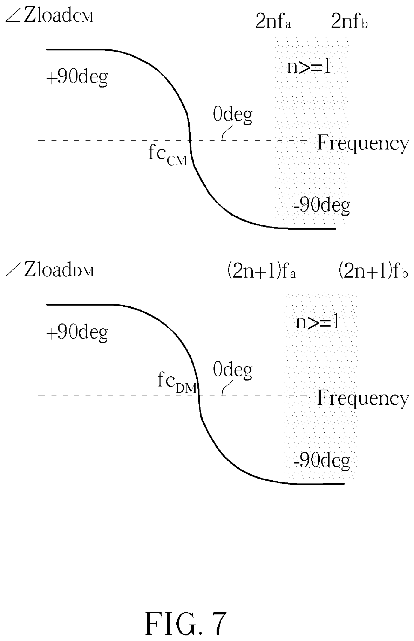

FIG. 7 is a schematic diagram showing the phase of the load when looking into the resonant circuit according to an embodiment of the invention, where n is a positive integer greater than 1. For the load looking into the resonant circuit, the reference may be made to FIG. 1, where the two arrows associated with the impedance of the load $Zload_{CM}$ indicate the path of the common-mode current flow and the two arrows associated with the impedance of the load $Zload_{DM}$ indicate the path of the differential-mode current flow.

As shown in FIG. 7, in the regions of capacitive load between frequencies $2nf_a$ and $2nf_b$ and between frequencies $(2n+1)f_a$ and $(2n+1)f_b$, the slop of the curve describing the phase $\angle Zload_{CM}$, as well as the slop of curve describing the phase $\angle Zload_{DM}$, is very small and approaches 0. This proves that the ISF will not change with oscillating frequency of the oscillator and the proposed oscillator circuit supports wideband operation. That is, the capability of flicker noise suppression is not degraded even when the oscillating frequency of the oscillator circuit changes. This is for illustration only, and the present invention is not limited thereto. Any load that does not vary significantly with frequency changes (i.e., a load that has a gentle slope) falls within the scope of the present invention.

In summary, in the embodiments of the invention, an oscillator circuit with flicker noise suppression achieved by phase-shifted self-injection is proposed. The proposed oscillator circuit has not only good flicker noise suppression capability, but also supports wideband operation. In addition, since only resistor(s) and capacitor(s) are required in the injection circuits, the injection circuits occupy very small circuit area. In comparison with the conventional designs, neither a second harmonic tail tank nor an additional tuning circuit or tuning mechanism is required. Therefore, compared to the conventional designs, the circuit area required in the proposed oscillator for compensating for the asymmetry of the ISF is greatly reduced.

Claims

1. An oscillator circuit (100, 300), **characterized by**:

   a first cross coupled pair (110, 310);
   a second cross coupled pair (120, 320);
   a resonant circuit (130), coupled between the first cross coupled pair (110, 310) and the second cross coupled pair (120, 320) and comprising a first node outputting a first voltage signal (VoscP) and a second node outputting a second voltage signal (VoscN); and
   a first injection circuit (140-1, 340-1), coupled to the first cross coupled pair (110, 310) and injecting a first compensating current with a first predetermined phase to a predetermined node of the first cross coupled pair (110, 310).

2. The oscillator circuit (100, 300) of claim 1, wherein the first cross coupled pair (110, 310) is **characterized by**:

   a first transistor (T11), comprising a first electrode, a second electrode and a third electrode; and
   a second transistor (T12), comprising a first electrode, a second electrode and a third electrode;
   wherein the first electrode of the first transistor (T11) is coupled to the second electrode of the second transistor (T12), and the first electrode of the second transistor (T12) is coupled to the second electrode of the first transistor (T11); and
   wherein the predetermined node is a node connecting to the third electrode of the first transistor (T11).

3. The oscillator circuit (100, 300) of claim 2, **characterized in that** the first electrode of the first transistor (T11) is coupled to the first node of the resonant circuit (130) and the first electrode of the second transistor (T12) is coupled to the second node of the resonant circuit (130), and wherein the first voltage signal is provided to the first injection circuit (140-1, 340-1).

4. The oscillator circuit (100, 300) of any one of claims 2 or 3, wherein the first injection circuit (140-1, 340-1) is **characterized by**:

   a filter circuit (210), coupled to the third electrode of the first transistor (T11) and receiving the first voltage signal (VoscP); and
   a feedthrough circuit (220), coupled to the filter circuit (210) and providing a current path between the third electrode of the first transistor (T11) and a power supply node.

5. The oscillator circuit (100, 300) of any one of claims 2 to 4, **characterized in that** the first injection circuit (140-1, 340-1) injects the first compensating current in response to the first voltage signal (VoscP), and the first predetermined phase is a 90-degree phase.

6. The oscillator circuit (100, 300) of any one of claims 2 to 5, further **characterized by**:

   a second injection circuit (140-2, 340-2), coupled to the third electrode of the second transistor (T12) and injecting a second compensating current with a second predetermined phase to the third electrode of the second transistor (T12);
   wherein the second voltage signal is provided to the second injection circuit (140-2, 340-2) and the second injection circuit (140-2, 340-2) injects the second compensating current in response to the second voltage signal (VoscN).

7. The oscillator circuit (100, 300) of any one of claims 1 to 6, wherein the second cross coupled pair (120, 320) is **characterized by**:

   a third transistor (T13), comprising a first electrode, a second electrode and a third electrode; and
   a fourth transistor (T14), comprising a first electrode, a second electrode and a third electrode, wherein the first electrode of the third transistor (T13) is coupled to the second electrode of the fourth transistor (T14), and the first electrode of the fourth transistor (T14) is coupled to the second electrode of the third transistor (T13);
   and the oscillator circuit (100, 300) further comprises:

      a third injection circuit (140-3, 340-3), coupled to the third electrode of the third transistor (T13) and injecting a third compensating current with a third predetermined phase to the third electrode of the third transistor (T13); and

a fourth injection circuit (140-4, 340-4), coupled to the third electrode of the fourth transistor (T14) and injecting a fourth compensating current with a fourth predetermined phase to the third electrode of the fourth transistor (T14);

wherein the first voltage signal (VoscP) is provided to the third injection circuit (140-3, 340-3), the third injection circuit (140-3, 340-3) injects the third compensating current in response to the first voltage signal (VoscP), the second voltage signal (VoscN) is provided to the fourth injection circuit (140-4, 340-4) and the fourth injection circuit (140-4, 340-4) injects the fourth compensating current in response to the second voltage signal (VoscN).

8. An oscillator circuit (100, 300), **characterized by**:

a first cross coupled pair (110, 310);

a second cross coupled pair (120, 320);

a resonant circuit (130), coupled between the first cross coupled pair (110, 310) and the second cross coupled pair (120, 320) and comprising a first node outputting a first voltage signal (VoscP) and a second node outputting a second voltage signal (VoscN); and

a plurality of injection circuits (140-1, 140-2, 140-3, 140-4, 340-1, 340-2, 340-3, 340-4), each being coupled to one of the first cross coupled pair (110, 310) and the second cross coupled pair (120, 320) and injecting a compensating current with a predetermined phase to a predetermined node of the one of the first cross coupled pair (110, 310) and the second cross coupled pair (120, 320);

wherein one of the injection circuits (140-1, 140-2, 140-3, 140-4, 340-1, 340-2, 340-3, 340-4) comprises:

a filter circuit (210), coupled to the predetermined node of the one of the first cross coupled pair (110, 310) and the second cross coupled pair (120, 320) and receiving one of the first voltage signal (VoscP) and the second voltage signal (VoscN); and

a feedthrough circuit (220), coupled to the filter circuit (210) and providing a current path between the predetermined node and a power supply node.

9. The oscillator circuit (100, 300) of claim 8, wherein the injection circuits are **characterized by**:

a first injection circuit (140-1, 340-1), coupled to the first cross coupled pair (110, 310);

a second injection circuit (140-2, 340-2), coupled to the first cross coupled pair (110, 310);

a third injection circuit (140-3, 340-3), coupled to the second cross coupled pair (120, 320); and

a fourth injection circuit (140-4, 340-4), coupled to the second cross coupled pair (120, 320).

10. The oscillator circuit (100, 300) of claim 9, wherein the first cross coupled pair (110, 310) is **characterized by**:

a first transistor (T11), comprising a first electrode, a second electrode and a third electrode; and

a second transistor (T12), comprising a first electrode, a second electrode and a third electrode;

wherein the first electrode of the first transistor (T11) is coupled to the second electrode of the second transistor (T12), and the first electrode of the second transistor (T12) is coupled to the second electrode of the first transistor (T11); and

wherein the first injection circuit (140-1, 340-1) is coupled to the third electrode of the first transistor (T11) and the second injection circuit (140-2, 340-2) is coupled to the third electrode of the second transistor (T12).

11. The oscillator circuit (100, 300) of any one of claims 9 or 10, wherein the second cross coupled pair (120, 320) is **characterized by**:

a third transistor (T13), comprising a first electrode, a second electrode and a third electrode; and

a fourth transistor (T14), comprising a first electrode, a second electrode and a third electrode;

wherein the first electrode of the third transistor (T13) is coupled to the second electrode of the fourth transistor (T14), and the first electrode of the fourth transistor (T14) is coupled to the second electrode of the third transistor (T13); and

wherein the third injection circuit (140-3, 340-3) is coupled to the third electrode of the third transistor (T13) and the fourth injection circuit (140-4, 340-4) is coupled to the third electrode of the fourth transistor (T14).

12. The oscillator circuit (100, 300) of any one of claims 9 to 11, **characterized in that** the first voltage signal (VoscP) is provided to the first injection circuit (140-1, 340-1) and the third injection circuit (140-3, 340-3), and the second voltage signal (VoscN) is provided to the second injection circuit (140-2, 340-2) and the fourth injection circuit (140-4, 340-4).

13. The oscillator circuit (100, 300) of any one of claims 9 to 12, **characterized in that** the first injection circuit (140-1, 340-1) injects a first compensating current in response to the first voltage signal (VoscP), the second injection circuit (140-2, 340-2) injects a second compensating current in response to the second voltage signal (VoscN), the third injection circuit (140-3, 340-3) injects a third compensating current in response to the first voltage signal (VoscP), and the fourth injection circuit (140-4, 340-4) injects a fourth compensating current in response to the second voltage signal (VoscN).

14. The oscillator circuit (100, 300) of any one of claims 8 to 13, **characterized in that** the predetermined phase is a 90-degree phase.

15. The oscillator circuit (100, 300) of any one of claims 8 to 14, **characterized in that** there is a 180-degree phase shift between the first voltage signal (VoscP) and the second voltage signal (VoscN).

100

140-3          VDD          140-4

VoscP— Injection circuit          Injection circuit —VoscN

T13          T14          120

130

∠Zload$_{CM}$          Resonant circuit

VoscP          VoscN

∠Zload$_{DM}$

T11          T12          110

VoscP— Injection circuit          Injection circuit —VoscN

140-1          140-2

FIG. 1

FIG. 2

FIG. 3

FIG. 4

FIG. 5

FIG. 6

EP 4 738 698 A1

$\angle$Zload$_{CM}$        2nf$_a$     2nf$_b$

+90deg

n>=1

0deg

Frequency

fc$_{CM}$

-90deg

$\angle$Zload$_{DM}$        (2n+1)f$_a$     (2n+1)f$_b$

+90deg

n>=1

fc$_{DM}$    0deg

Frequency

-90deg

FIG. 7

Europäisches
Patentamt
European
Patent Office
Office européen
des brevets

# EUROPEAN SEARCH REPORT

**Application Number**

EP 25 18 3987

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | CN 104 852 732 A (INST ADVANCED TECHNOLOGY UNIV SCIENCE & TECHNOLOGY CHINA) 19 August 2015 (2015-08-19) | 1-6,8, 14,15 | INV. H03B5/12 |
| A | * figure 3 * | 7,9-13 | |
| X | SHASIDHARAN PRAVINAH ET AL: "A 2.2 to 2.9 GHz Complementary Class-C VCO With PMOS Tail-Current Source Feedback Achieving - 120 dBc/Hz Phase Noise at 1 MHz Offset", IEEE ACCESS, vol. 7, 5 July 2019 (2019-07-05), pages 91325-91336, XP011736396, DOI: 10.1109/ACCESS.2019.2927031 [retrieved on 2019-07-23] | 1,2 | |
| A | * figure 2 * | 3-15 | |
| X | US 2008/266007 A1 (TSAI MING-DA [TW]) 30 October 2008 (2008-10-30) | 1 | |
| A | * figure 9 * | 2-15 | |

**TECHNICAL FIELDS SEARCHED (IPC)**

H03B

The present search report has been drawn up for all claims

| Place of search | Date of completion of the search | Examiner |
|---|---|---|
| Munich | 2 December 2025 | Schnabel, Florian |

EPO FORM 1503 03.82 (P04C01)

## ANNEX TO THE EUROPEAN SEARCH REPORT
## ON EUROPEAN PATENT APPLICATION NO.

EP 25 18 3987

This annex lists the patent family members relating to the patent documents cited in the above-mentioned European search report.
The members are as contained in the European Patent Office EDP file on
The European Patent Office is in no way liable for these particulars which are merely given for the purpose of information.

02-12-2025

| Patent document cited in search report | | Publication date | Patent family member(s) | | Publication date |
|---|---|---|---|---|---|
| CN 104852732 | A | 19-08-2015 | NONE | | |
| US 2008266007 | A1 | 30-10-2008 | CN | 101295962 A | 29-10-2008 |
| | | | TW | 200843352 A | 01-11-2008 |
| | | | US | 2008266007 A1 | 30-10-2008 |

EPO FORM P0459

For more details about this annex : see Official Journal of the European Patent Office, No. 12/82